# EUROPEAN PATENT SPECIFICATION

(11) **EP 0 206 180 B1**
(45) Date of publication and mention of the grant of the patent: **29.09.1993**
(21) Application number: 86108138.8
(22) Date of filing: 13.06.1986
(51) Int. Cl.: H05K 13/00, H05K 13/02, H01L 21/00, C23C 14/56

(54) **A means for loading or unloading workpiece into or from a vacuum processing chamber**
Vorrichtung zum Beschicken oder Entnehmen eines Werkstückes in eine oder aus einer Kammer für Vakuumbehandlung
Dispositif pour l'introduction ou le retrait d'une pièce d'ouvrage dans ou hors d'une enceinte pour le traitement sous vide

(30) Priority: 17.06.1985 JP 131013/85
(43) Date of publication of application: 30.12.1986
(73) Proprietor: FUJITSU LIMITED, Kawasaki-shi, Kanagawa 211 (JP)
(72) Inventor: Arii, Katsuyuki, Tama-shi Tokyo, 206 (JP)
(74) Representative: Schmidt-Evers, Jürgen, Dipl.-Ing.

(56) References cited:
- DE-A- 2 100 725
- DE-A- 2 834 353
- US-A- 3 656 454
- PATENT ABSTRACTS OF JAPAN vol. 6, no. 139 (C-116) 1017 28 July 1982, & JP-A-57 63677
- PATENT ABSTRACTS OF JAPAN vol. 9, no. 134 (C-285) 1857 08 June 1985, & JP-A-60 21375

## Description

### FIELD OF THE INVENTION

The present invention relates to a device for loading or unloading a workpiece into or from a processing vacuum chamber which is used for semiconductor production and the like, and more particularly relates to a vacuum chamber in which dust contamination of workpieces should be strictly avoided.

### PRIOR ART

Vacuum chamber is widely used for chemical and physical processing, such as evaporation, sputtering, ion plating, etching etc., of such as semiconductor materials. Recent VLSI (Very Large Scale Integrated Circuit) requires a fabrication preciseness of sub-micron meter, and the size of IC chips and the size of the wafer on which the ICs are fabricated are both becoming larger. This fact means that the number of dusts contaminating the workpiece should be more strictly reduced, because the number of the dusts on an IC chip directly affects yields and quality of the production.

Therefore, reduction of the number of the dusts within the atmosphere in which the workpiece is processed becomes essential requirement to achieve high quality and production yield of VLSI.

There are several modes which cause dust contamination of workpiece in a vacuum chamber. The first mode is a contamination caused by dusts which have already deposited on the workpieces or tools such as transfer devices before they are taken into the vacuum chamber. The second mode is that caused by the dusts already included in the air/gas in the vacuum chamber before it is evacuated. The third mode is that caused by dusts which have already deposited on various parts within the chamber and are blown up by a turbulent flow of air/gas while air/gas is evacuated or introduced.

There have been made extensive efforts to reduce the dusts in the processing atmosphere.

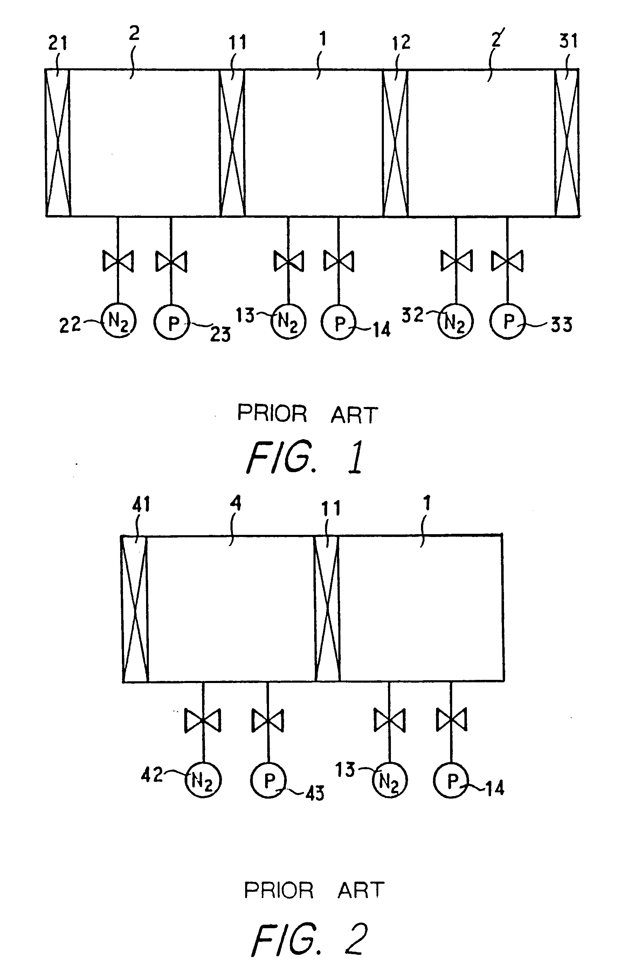

Particularly in order to overcome the above described third mode problem, there have been widely used loading and unloading chamber (they will be referred to simplify as a load chamber hereinafter). Examples are shown in Figs. 1 and 2. In the figures, a loading chamber 2, 2' or 4 is provided coupled to a processing chamber 1 where the workpiece is processed. Via these loading chambers, the workpiece is brought in or taken out into or from a processing chamber 1. The loading chamber 2, 2' or 4 is connected to the processing chamber 1 through A gate 11 or 12 capable to be opened or closed vacuum-tightly.

A system shown in Fig. 1 is provided with a vacuum chamber 2 exclusively used for loading workpiece into the processing chamber 1, and another vacuum chamber 2' exclusively used for unloading workpiece from the processing chamber 1.

A system of Fig. 2 is provided with one loading chamber 4 used for both loading and unloading workpiece into or from the processing chamber 1. These two types of loading and unloading chamber system are so-called load-lock system.

With reference to Figs. 1 and 2, the procedure of loading and unloading workpiece into or from the processing vacuum chamber 1 is as follows.

A gate 21 of the loading chamber 2 (Fig.1) or a gate 41 of loading chamber 4 (Fig.2) is opened. Workpiece is introduced through the opened gate 21 or 41 and placed in the loading chamber 2 or 4, then the gate is closed and waited several minutes until the floating dusts in air/gas fall down. Then, the loading chamber 2 or 4 is evacuated by a vacuum pump 23 or 43. Gate 11 to the processing chamber 1, which is evacuated by a pump 14 in advance, is opened and the workpiece is transferred into the processing chamber 1.

For unloading workpiece from the processing chamber 1 of Fig. 1 or 2, the loading chamber 2' or 4 is evacuated by a vacuum pump 33 or 43, and a gate 12 between the chamber 1 and 2' or gate 11 between the chamber 1 and 4 is opened, and the workpiece is transferred from processing chamber 1 to the loading chamber 2' or 4 through the opened gate 12 or 11. After the gate 12 or 11 is closed, a gas introduction means 32 or 42 fills the chamber 2' or 4 with air/gas, and then a gate 31 or 41 is opened to take out the workpiece from the loading chamber 2' or 4.

The above described air/gas to be introduced into the loading chamber 2, 2' or 4 is strictly filtered by a filtering means (not shown) to minimize the numbers of dust contained therein. Inert gas, such as pure nitrogen, is generally used to avoid introduction of chemically active gas which may harm the workpiece. The word "gas" will be used hereinafter to represent air/gas of above described meaning.

In the above described prior art vacuum chamber system comprising loading chambers, during the evacuation or gas introduction cycle of chamber 1, the dusts which are already deposited on various parts of the chamber are blown up, but the workpiece is not existing in the processing chamber. And, when workpiece is taken into or from the processing chamber 1, the processing chamber is already evacuated and floating dusts all have fallen down because dust can not float in vacuum, therefore there is no trouble in the processing vacuum chamber 1.

However, in the loading chamber, during its evacuation or gas introduction cycle, there still are dusts already deposited on various parts of the loading chamber, blown up by a turbulent flow of gas and may possibly fall to deposit on the workpiece. Such contamination corresponds to the third mode described above.

To reduce dusts in the loading or unloading chamber, several other methods have been proposed. For example, provisional publication of Japanese Patent, TOKUKAI 60-27114, February 12, 1985 by Tsuchiya discloses a method for reducing dusts deposition already existing upon surfaces of various portions within the chamber. This method comprises a procedure of repeating gas introduction and evacuation of chamber, before workpiece is brought thereinto. A turbulent flow of the gas introduction blows up deposited dusts into the gas atmosphere in the chamber, and by evacuating this gas, the floating dusts in the gas are also exhausted together with the gas. Repetition of this cycle reduces number of dusts remained within the chamber.

Though prior arts, as described above, are effective for some level, there still exist increasing requirements for more reduction of dust deposition on the workpiece to achieve better yields and better quality of VLSI production.

### SUMMARY OF THE INVENTION

It is a general object and advantage of the present invention to provide a means for extremely reducing dusts deposition on workpiece in a vacuum chamber system.

Further object and advantage of the present invention is to provide a system in which workpiece is protected from deposition of dusts during evacuation and gas introduction cycle of the vacuum chamber.

Another object of the present invention is to increase the production yield and improve the characteristics of ICs.

The present invention provides a second vacuum chamber (hereafter called second chamber) within a loading chamber via which workpiece is loaded in or unloaded out from/to open-air area. The second chamber is capable to be opened and closed to the room of the loading chamber, and keeps the workpiece in it protected from the blown up dusts while the loading chamber is being evacuated or gas-introduced. The room of the loading chamber outside of the second chamber 5 will be abbreviated as main chamber and denoted by index numeral 3 hereinafter.

Gas pressure in the second chamber is always kept higher or at least the same to that of the main chamber. This pressure difference between the second chamber and the main chamber prevents dust intrusion from the main chamber into the second chamber.

In order to keep above described pressure difference, various means, as pressure control means, are proposed by the present invention.

The second chamber may comprise a slow leak means for sealing against the main chamber. In an evacuation process, the main chamber is evacuated first, and when the pressure difference between the main chamber and the second chamber reaches to some level, the slow leak means allows the inner gas in the second chamber to leak out to the main chamber. For a gas introduction process, the second chamber is provided with a gas introduction means by which the second chamber is filled with gas first, and next the main chamber is filled with gas by another gas introduction means thereof.

The second chamber may comprise another evacuation means to speed up the evacuation thereof.

The second chamber may be shaped like a bell jar, movable up and down in the main chamber, and the bottom of the bell jar is opened when it is lifted up by a shifting means, and is closed by a table when the bell jar is lowered onto it.

A transfer means to transfer a work piece is located at the outside of the second chamber, so that the volume of the second chamber can be small resulting in less chance of dust introduction therein.

The main chamber is connected to a processing chamber and a second gate means is provided between the main chamber and the processing chamber for transferring work piece between the main chamber and the processing chamber, and the work piece is loaded in or unloaded from the processing chamber via the main chamber.

The loading chamber may be used for both loading and unloading workpiece into and from the processing chamber. In some case, two load chambers may be used respectively for loading and unloading.

These together with other objects and advantages, which will be subsequently apparent, reside in the details of construction, as more fully hereinafter described and claimed.

### BRIEF DESCRIPTION OF THE DRAWINGS

Fig. 1 schematically illustrates a prior art vacuum chamber system employing two loading chambers, one for loading and one for unloading workpiece into or from a processing chamber.

Fig. 2 schematically illustrates a prior art vacuum chamber system employing one loading chamber for both loading and unloading workpiece into or from a processing chamber.

Fig. 3 schematically illustrates a vacuum chamber system in accordance with the present invention employing one loading chamber for both loading and unloading workpiece into or from a processing chamber.

Figs. 4-8 schematically illustrate successive steps of loading procedure at the system of the present invention shown in Fig. 3, wherein:

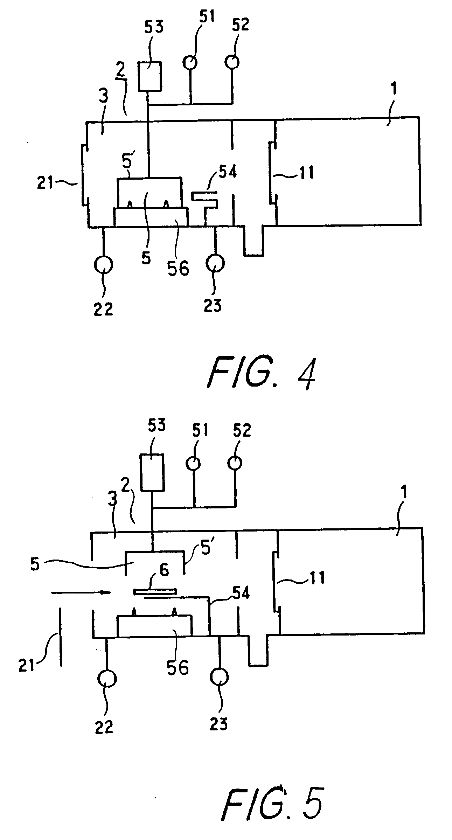

Fig. 4 illustrates a state that the main chamber is filled with gas in preparation for receiving workpiece from the outside;
Fig. 5 illustrates a state that the gate of the main chamber and the second chamber are opened, and the workpiece is being placed on a transfer means;

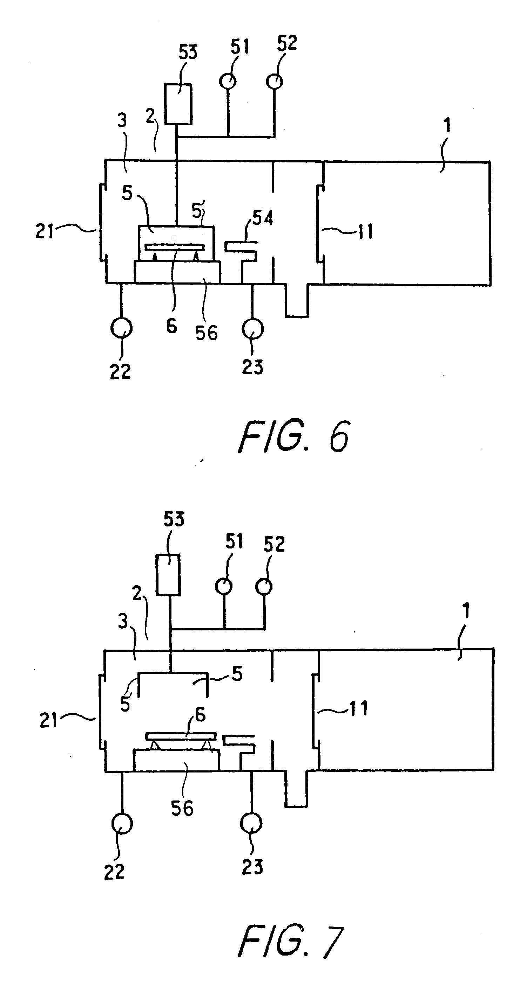

Fig. 6 illustrates a state that the gate of the main chamber and the second chamber is closed, and the both chambers are being evacuated;
Fig. 7 illustrates a state that the second chamber is opened; and

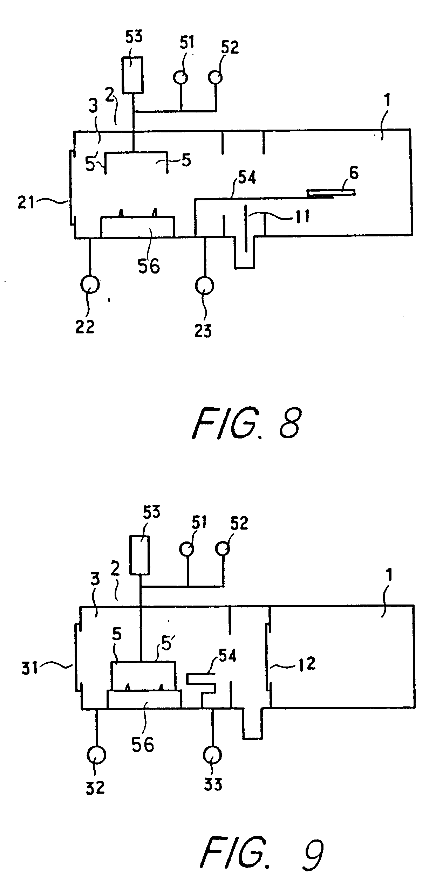

Fig. 8 illustrates a state that the gate between the main chamber and the processing chamber is opened, and the workpiece is transferred into the processing chamber by a transfer means.

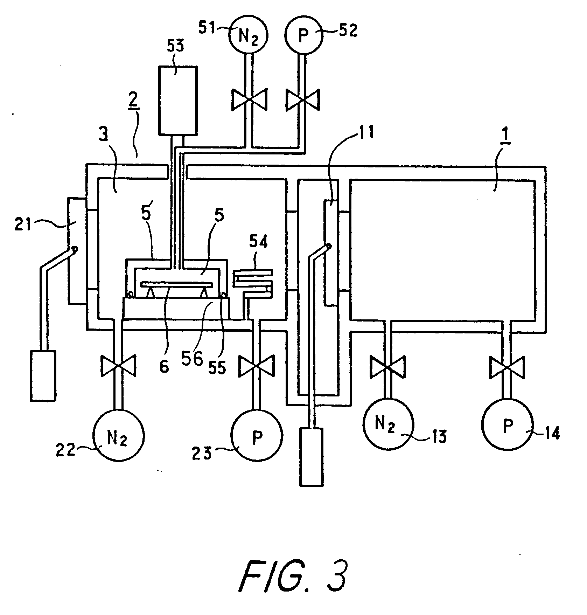

Figs. 9-12 schematically illustrate successive steps of unloading procedure at the system of the present invention shown in Fig. 3, wherein:
Fig. 9 illustrates a state that the main chamber and the second chamber are being evacuated in preparation for receiving the workpiece from the processing chamber;

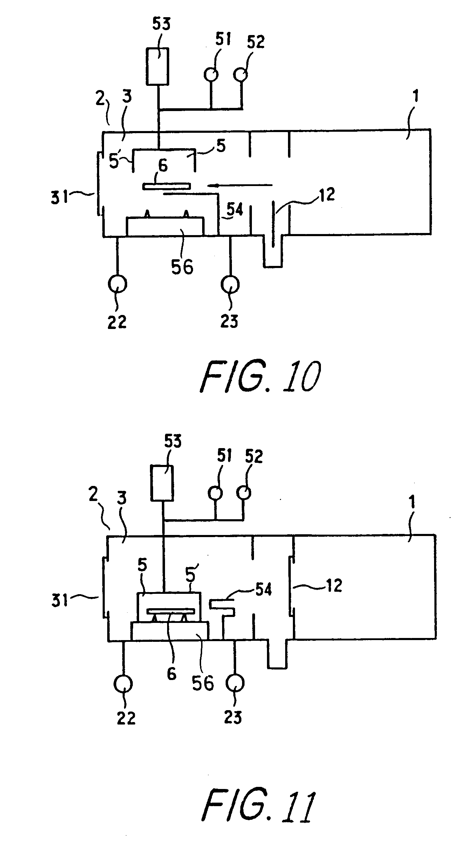

Fig. 10 illustrates a state that the gate between the processing chamber and main chamber is opened, and the work piece is transferred by a transfer means into the second chamber;
Fig. 11 illustrates a state that the second chamber, and the gate between the processing chamber and the main chamber is closed, and the main chamber and the second chamber are being filled with gas; and

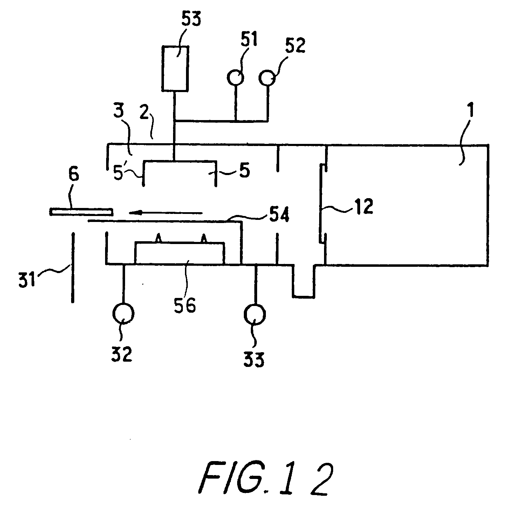

Fig. 12 illustrates a state that the second chamber and the gate to the outside are both opened, and the work piece is taken out by the transfer means to outside.

Fig. 13 schematically illustrates a second embodiment of the present invention, in which two loading chambers are provided for loading and for unloading the workpiece respectively, and the second chambers are applied in each main chamber.

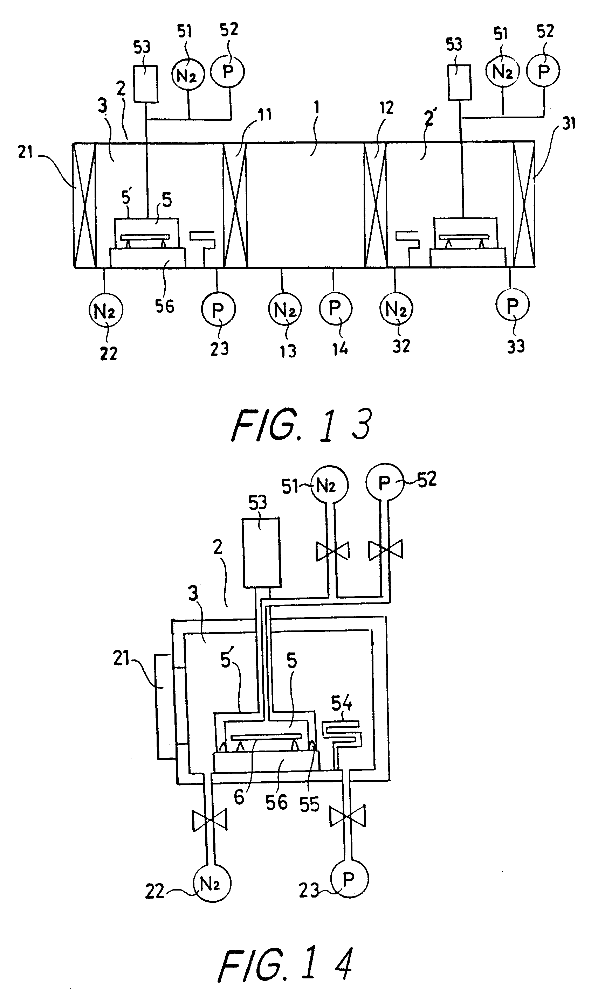

Fig. 14 schematically illustrates a third embodiment of the present invention, in which the second chamber is applied to a processing chamber, and workpiece is directly loaded and unloaded into and from the processing chamber.

Throughout the drawings, the same or similar reference numerals designate and identify the same or similar parts.

### DESCRIPTION OF THE PREFERRED EMBODIMENT

Referring now to the embodiment of the invention illustrated in Fig. 3, there is shown a loading chamber 2 for both loading and unloading workpiece into and from a processing chamber 1. It corresponds to the prior art system shown in Fig. 2.

The processing chamber 1 is provided with a vacuum pump 14 and a gas introduction means 13 for intentionally introducing a filtered air or inert gas, such as pure nitrogen, into the processing chamber 1. The processing chamber 1 is used for a physical or chemical processing, such as sputtering or etching and so on. The means for these processing are not shown hereinafter in the figures for the simplicity.

The loading chamber 2 is provided with a gate 21 which is capable to be vacuum-tightly closed or opened to the outside of the loading chamber 2, a second gate 11 which is capable to be vacuum-tightly closed or opened to the processing chamber 1, a vacuum pump 23, a gas introduction means 22 and a transfer means 54 to transfer workpiece 6 from or into the second chamber 5 to or from the processing chamber 1. These are of conventional ones.

In addition to these conventional ones, according to the present invention, the loading chamber 2 is provided with a second chamber 5 in which a workpiece 6 is placed, gas introduction means 51 to introduce gas into the second chamber 5, and a vacuum pump 52 to evacuate the second chamber 5. The second chamber 5 is separated from the main chamber 3 by a bell jar 5' having its opening at its bottom and having a loosely vacuum tight sealing 55, as a slow leak means, at the periphery of the bottom opening of the bell jar 5'. The slow leak means 55 can be consist of a finely finished flat edge of the opening of the bell jar and a finely finished flat surface of the table 56 on which the bell jar sits down, or consist of an O-ring for example.

The bell jar 5' is also provided with a driving means 53 to lift up and down the bell jar 5'. The driving means 53 can comprise a stroke means, a hydraulic or air cylinder for example and a contact pressure control means, a spring for example, to provide an appropriate seal leakage of the bell jar 5' to the main chamber 3.

Procedure of loading workpiece 6 into the processing chamber 1 is as follows and illustrated by the successive steps in Figs. 4-8:

As shown in Fig. 4, filtered pure nitrogen gas is introduced into the second chamber 5 by the gas introduction means 51, while the gate 11 and 21 are closed. When the gas pressure of the second chamber 5 reaches higher than that of the gas pressure of the main chamber 3, the gas in the second chamber 5 begins to leak through the slow leak means 55 (Fig. 3) into the main chamber 3 which has been kept in vacuum. After the gas introduction into the second chamber 5, filtered pure nitrogen gas is introduced into the main chamber 3 through a gas introduction means 22.

The gas pressure in the second chamber 5 is always kept to the same or higher than that in the main chamber 3 during above described gas introduction process, so that dusts can not intrude into the second chamber 5 from the main chamber 2.

During the gas introduction process, dusts within both chambers are blown up to float in the gas by a turbulent flow of the introduced gas.

After the gas pressure reaches to the atmospheric pressure, both chambers are kept waiting several minutes until the floating dusts fall down.

Next, as shown in Fig. 5, gate 21 is opened and the bell jar 5' is lifted up by the driving means 53. Workpiece 6 is placed on the transfer means 54, a carrier which transfers and loads the workpiece 6 on a table 56 in the second chamber 5. And the bell jar 5' is lowered by the driving mechanism 53 to seal the second chamber 5.

Then, as shown in Fig. 6, the main chamber 2 is evacuated by a vacuum pump 23, and then the second chamber 5 is evacuated by a vacuum pump 52. During this evacuating period, the gas pressure of the second chamber 5 is kept higher than that of the main chamber 3. When the pressure reaches a vacuum lower than 1 milli-Torr., dusts can not float any more in the space, and fall down. At this time, in a vacuum chamber system of prior art, dusts in the main chamber 3 fall onto the workpiece, because the workpiece is not covered. However, according to the present invention, dusts in the main chamber 3 do not fall onto the workpiece because it is covered by the bell jar 5'. Dusts in the second chamber 5 may fall onto the workpiece, however, the number of dusts existing in the second chamber 5 is quite less compared with that in the main chamber 3. Because the number of the dusts in the chamber is approximately proportional to the volume of the chamber. So, the volume of the chamber 5 is made as small as possible to cover the workpiece. Further, in order to make the second chamber 5 small and to avoid a chance of introducing dusts into the chamber 5, the carrier 54, for example, and other equipments and tools in the loading chamber are located outside of the second chamber 5.

Succeedingly, as shown in Fig. 7, the bell jar 5' is opened by the driving means 53. At this time, no dust deposits onto the workpiece 6, because no turbulent flow occurs by this opening action. And also, dusts are not existing in the space, since dusts can not float in vacuum.

Next, as shown in Fig. 8, the gate 11 is opened, and the carrier 54 transfers workpiece 6 from the main chamber 3 to the processing chamber 1, which has been already evacuated and no dusts are floating in the space. Then, the gate 11 is closed to complete the loading process.

Procedure of unloading workpiece from the processing chamber 1 is as follows and illustrated by the successive steps in Figs. 9-12.

As shown in Fig. 9, the main chamber 3 is evacuated by an evacuating means 33, a vacuum pump for example. When the pressure difference between the main chamber 3 and the second chamber 5 reaches to some extent, the slow leak seal 55 begins to allow the gas in the second chamber 5 to leak into the main chamber 3. The second chamber 5 may also be provided with an evacuating means 52, a vacuum pump for example, to evacuate it independently and speedily, but attention has to be paid to keep the pressure of the second chamber 5 to the same or higher than that of the main chamber 3.

As shown in Fig. 10, a gate 12 between the processing chamber 1 and unloading chamber 2 is opened. Opening the gate 12 does not cause a turbulent gas flow because both the chambers are in vacuum already, therefore no dusts fall on the workpiece. Through the opened gate 12, the workpiece 6 is transferred by the carrier 54 from the processing chamber 1 into the second chamber 5, and placed on the table 56 under the bell jar 5'.

Next, as shown in Fig. 11, the bell jar 5' is lowered driven by the driving means 53, and closed. A gas introduction means 51 introduces filtered gas (nitrogen gas for example) into the second chamber 5 until the pressure reaches to atmospheric pressure. The air introduction means 22 also introduces filtered pure gas into the main chamber 3, while keeping the gas pressure of the second chamber 5 is the same or higher than that of the main chamber 3.

The speed of gas introduction into the second chamber 5 is controlled slow enough to suppress the generation of a turbulent gas flow therein. Therefore, although there are some dusts deposited on the inner surface of the second chamber 5, the chance of dusts deposition on the workpiece during the gas introduction period is very rare.

According to conventional unloading chamber which does not employ the second chamber 5, it takes as long as more than 5 minutes to fill the unloading chamber 3 having a volume of 12 litre for example, because the gas must be introduced slowly. On the contrast, according to the present invention, the second chamber 5 is made less than 1.2 litre in volume, for example, so it takes only 30 second to fill the chamber with gas under controlled speed of gas introduction. Since the workpiece 6 is covered by the bell jar 5', no speed control of gas introduction is required to fill the large main chamber 3. Therefore, the unloading chamber 3 can be filled up very quickly. This is a considerable contribution to save total time required for processing and to result in increased production rate.

Next, both the chambers are held calm for several minutes until the floating dusts fall down. Then as shown in Fig. 12, the gate 31 and the second chamber 5 are both opened, and the carrier 54 takes out the workpiece 6 from the the second chamber 5 to outside of the loading chamber 2 through the opened gate 31 to complete an unloading process.

According to data taken by the inventor, the number of dust particles larger than 0.11 micron meter floating in the gas within a loading chamber is some 10,000s per cubic feet when the gas is introduced in to fill a vacuum chamber, and the particle number decreases relatively fast down to less than 100 per cubic feet in 3 minutes of calming down time, but the decreasing speed becomes very slow thereafter. This means almost 99% of floating dusts fall and deposit on the surfaces of equipments or parts and workpiece in 3 minutes.

During the evacuation cycle, some of the dusts are exhausted out by the vacuum pump, but the dusts which had been existing in the space above the work piece will fall down on to the workpiece. The number of the fallen dusts is roughly proportional to the height of the space existed over the workpiece. Therefore, the low height of the second chamber 5 contributes to decrease the number of the fallen dusts on the workpiece.

The number of deposited dusts is also related to the number of the dusts already existing in the chamber, therefore, the the volume of the second chamber 5 should be made as small as possible.

In the above described embodiment, the number of dust particle deposited on the workpiece is decreased to less than one tenth of the prior art's.

It is another advantage of the present invention that the workpiece is protected from an unwanted contamination of harmful gas used in the processing chamber 1 for dry etching, for example. Even though the processing chamber 1 is evacuated after dry etching process, some amount of harmful etching gas remains adsorbed on surfaces of the transfer means 54 etc., which invades into the loading chamber. This adsorbed gas is feasible to evaporate during evacuation cycle of the loading chamber 2 and to adsorb on any other surface within the chamber and the workpiece. Repetition of such cycle of procedure increases adsorption of harmful gas and its re-evaporation may possibly contaminate the workpiece.

In accordance to the present invention, however, there is no chance of exposing the inside of the second chamber 5 to the harmful gas vapor. This means that the chance of exposing workpiece to the harmful gas is avoided by the present invention.

Second embodiment of the present invention used for a load-lock system corresponding to Fig. 1 of prior art, is schematically illustrated in Fig. 13, wherein one loading chamber 2 is provided exclusively for loading workpiece 6, and another loading chamber 2' is provided exclusively for unloading workpiece 6 from work chamber 1. The steps of loading and unloading workpiece are similar to those described with respect to Figs. 4-12. Same or similar index numerals designate same or similar parts in the figures.

The advantage of this system is a faster cycling of loading and unloading process than the first embodiment, and results in better production rate.

Fig. 14 schematically illustrates the third embodiment of the present invention, which is applied directly to a processing chamber to load and unload the workpiece without passing through the loading chamber. In this embodiment, the loading chamber 2 itself becomes a processing chamber.

Though they are not shown in the figure, necessary equipments or tools for processing the workpiece must be provided in the main chamber 3. If such equipments or tools are provided in the main chamber 3, the chance of contamination increases, but the second chamber 5 protects the workpiece and its contamination is avoided. The advantage of this embodiment is the simplicity of the structure, and applicable to so-called batch system.

In the above described disclosure, the workpiece 6, a semiconductor wafer for example, is held horizontally in the second chamber, however, it does not exclude holding the main surface of the workpiece vertically or up-side-down. The advantage of such holding mode is to avoid vertical falling down of dusts deposition on the main surface of the workpiece.

While nitrogen gas is referred as representative with respect to the embodiments, it is to be understood that other gas, such as air, may be applicable depending on individual case.

## Claims

1. A means for loading or unloading a workpiece (6) into or from a vacuum chamber for processing the workpiece (6) in said vacuum chamber (1), comprising;
a main chamber (3) coupled to said vacuum chamber (1), through said main chamber (3) the workpiece (6) are loaded or unloaded to or from said vacuum chamber (1); an evacuation means (23) for evacuating said main chamber (3);
a gas introduction means (51) for introducing gas into said main chamber (3);
a first gate means (21) for loading or unloading said workpiece (6) into or from said main chamber (5), said first gate means (21) capable of opening or sealing vacuum tighthly an opening provided on wall between said main chamber (3) and outside of said main chamber (3);
a second gate means (11) provided between said vacuum chamber (1) and said main chamber (3) for transferring said workpiece (6) from said main chamber (3) into said vacuum chamber (1) or vice versa, said second gate means (11) capable of opening or sealing vacuum tightly an opening provided on wall between said vaccum chamber (1) and said main chamber (3);
a table (56) provided in said main chamber (3) on which said workpiece (6) is placed; and
a second chamber (5) provided in said main chamber (3) for enclosing said workpiece (6) in it, and keeping said workpiece (6) in isolation from said main chamber (3) while said main chamber (3) is in evacuation or gas introduction process.

2. A means according to said claim 1, further comprising a pressure control means for keeping gas pressure in said second chamber (5) higher or at least equal to that of the main chamber (3).

3. A means according to said claim 2, wherein said pressure control means comprises a second gas introduction means (51) for introducing gas into said second chamber (5).

4. A means according to said claim 2, wherein said pressure control means comprises a second evacuation means (52) for evacuating said second chamber (5).

5. A means according to claim 2, wherein said pressure control means comprises a slow leak means provided to periphery of bottom opening of said bell jar (5').

6. A means according to said claim 5, wherein said slow leak means being an O-ring (55) attached to opening of said bell jar (5').

7. A means according the said claim 1, wherein said second chamber (5) being large enough to enclose said workpiece (6) in it but being as small as possible.

8. A means according to said claim 1, wherein said second chamber is composed of a bell jar (5') movable up and down in said main chamber (3), bottom of said bell jar (5') is opened when it is lifted up, and is closed contacting with said table (56) when said bell jar (5') is lowered to sit on said table (56).

9. A means according to said claim 8, further comprising a shifting means (53) to lift up or down said bell jar (5').

10. A means according to claim 1, further comprising a transfer means (54), located at outside of said second chamber (5), for transferring said workpiece (6), positioning said workpiece (6) on said table (56) or picking up said workpiece (6) to or from said table (56).

11. A vacuum processing chamber for processing a workpiece (6) in it, comprising:
a main chamber (3) for processing said workpiece (6) in it;
an evacuation means (23) for evacuating said main chamber (3);
a gas introduction means (22) for taking gas into said main chamber (3);
a gate means (21, 11) for loading or unloading said work-piece (6) into said main chamber (3), said gate means (21, 11) capable of opening or sealing vacuum tightly an opening provided on wall between said main chamber (3) and outside of said main chamber (3);
a table (56) provided in said main chamber (3) on which said workpiece (6) is placed; and
a second chamber (5) provided in said main chamber (3) for enclosing said workpiece (6) in it, and keeping said workpiece (6) inisolation from said main chamber (3) while said main chamber (3) is in evacuation or gas introduction process.

12. A vacuum processing chamber according to said claim 11, further comprising a pressure control means for keeping gas pressure in said second chamber (5) higher or at least equal to that of the main chamber (3).

13. A vacuum processing chamber according to said claim 12, wherein said pressure control means comprises a second gas introduction means (51) for introducing gas into said second chamber (5).

14. A vacuum processing chamber according to said claim 12, wherein said pressure control means comprises a second evacuation means (52) for evacuating said second chamber (5).

15. A vacuum processing chamber according to claim 12, wherein said pressure control means comprises a slow leak means provided to periphery of bottom opening of said bell jar (5').

16. A vacuum processing chamber according to said claim 15, wherein said slow leak means being an O-ring (55) attached to opening of said bell jar (5').

17. A vacuum processing chamber according the said claim 11, wherein said second chamber (5) being large enough to enclose said workpiece (6) in it but being as small as possible.

18. A vacuum processing chamber according to said claim 11, wherein said second chamber is composed of a bell jar (5') movable up and down in said main chamber (3), bottom of said bell jar (5') is opened when it is lifted up, and is closed contacting with said table (56) when said bell jar (5') is lowered to sit on said table (56).

19. A vacuum processing chamber according to said claim 11, further comprising a shifting means (53) to lift up or down said bell jar (5').

20. A means according to claim 11, further comprising a transfer means (54), located at outside of said second chamber (5), for transferring said workpiece (6) and positioning said workpiece (6) on said table (56) or picking up said workpiece (6) from said table (56).

## Patentansprüche

1. Vorrichtung zum Ein- und/oder Ausbringen eines Werkstücks (6) in oder aus einer Vakuumkammer zur Behandlung des Werkstücks (6) in der Kammer (1), mit:
einer an die Vakuumkammer (1) gekoppelten Hauptkammer (3), durch welche Hauptkammer (3) das Werkstuck (6) in die Vakuumkammer (1) ein- und/oder aus der Vakuumkammer (1) ausbringbar ist,
einer Evakuierungseinrichtung (23) zum Evakuieren der Hauptkammer (3),
einer Gaseinbringeinrichtung (51) zum Einbringen von Gas in die Hauptkammer (3),
einer ersten Toreinrichtung (21) zum Ein- und/oder Ausbringen des Werkstücks (6) in oder aus der Hauptkammer (5), wobei durch die erste Toreinrichtung (21) eine in einer Wand zwischen der Hauptkammer (3) und der Außenseite der Hauptkammer (3) vorgesehene Öffnung vakuumdicht geschlossen und/oder geöffnet werden kann,
einer zwischen der Vakuumkammer (1) und der Hauptkammer (3) vorgesehenen zweiten Toreinrichtung (11) zum Überfuhren des Werkstücks (6) von der zweiten Hauptkammer (3) in die Vakuumkammer (1) und/oder umgekehrt, wobei durch die zweite Toreinrichtung (11) eine in der Wand zwischen der Vakuumkammer (1) und der Hauptkammer vorgesehene Öffnung vakuumdicht geschlossen und/oder geöffnet werden kann,
einer in der Hauptkammer (3) vorgesehenen Auflage (6), auf welcher das Werkstück (6) plaziert ist, und
einer in der Hauptkammer (3) vorgesehenen zweiten Kammer (5) zum Anordnen des Werkstücks (6) in dieser zweiten Kammer (5) und Isolierthalten des Werkstücks (6) von der Hauptkammer (3), während die Hauptkammer (3) evakuiert ist und sich in einem Gaseinbringprozeß befindet.

2. Vorrichtung nach Anspruch 1 mit einer Drucksteuereinrichtung zum Halten eines Gasdrucks in der zweiten Kammer (5), der höher oder wenigstens gleich dem Druck in der Hauptkammer (3) ist.

3. Vorrichtung nach Anspruch 2, wobei die Drucksteuereinrichtung eine zweite Gaseinbringeinrichtung (51) zum Einbringen von Gas in die zweite Kammer (5) aufweist.

4. Vorrichtung nach Anspruch 2 oder 3, wobei die Drucksteuereinrichtung eine zweite Evakuierungseinrichtung (52) zum Evakuieren der zweiten Kammer (5) aufweist.

5. Vorrichtung nach Anspruch 2, 3 oder 4, wobei die Drucksteuereinrichtung eine an der Peripherie einer Bodenöffnung einer Vakuumglocke (5') vorgesehene Langsamleckeinrichtung aufweist.

6. Vorrichtung nach Anspruch 5, wobei die Langsamleckeinrichtung aus einem an der Öffnung der Vakuumglocke (5') angebrachten O-Ring (55) besteht.

7. Vorrichtung nach einem der vorhergehenden Ansprüche, wobei die zweite Kammer (5) eine Größe aufweist, die ausreicht, das Werkstück (6) in der zweiten Kammer (5) aufzunehmen, die ansonsten aber so klein wie möglich ist.

8. Vorrichtung nach einem der vorhergehenden Ansprüche, wobei die zweite Kammer (5) aus einer in der Hauptkammer (3) auf- und abwärtsbewegbaren Vakuumglocke (5') gebildet ist, wobei der Boden der Vakuumglocke (5') geöffnet ist, wenn sie angehoben ist und unter Berührung der Auflage (56) geschlossen ist, wenn sie abgesenkt ist, um auf der Auflage (56) zu sitzen.

9. Vorrichtung nach Anspruch 8 mit einer Betätigungseinrichtung (53) zum Anheben und/oder Absenken der Vakuumglocke (5').

10. Vorrichtung nach einem der vorhergehenden Ansprüche, mit einer auf der Außenseite der zweiten Kammer (5) angeordneten Überführungseinrichtung (54) zum Überführen des Werkstücks (6), Positionieren des Werkstücks (6) auf der Auflage (56) und/oder Aufnehmen des Werkstücks (6) zur Auflage (56) in oder von der Auflage (56) fort.

11. Vakuumbehandlungskammer zur Behandlung eines Werkstücks (6) in ihr, mit:
einer Hauptkammer (3) zur Behandlung des Werkstücks (6) in ihr,
einer Evakuierungseinrichtung (23) zur Evakuierung des Hauptkammer (3),
einer Gaseinbringeinrichtung (22) zum Einbringen von Gas in die Hauptkammer (3),
einer Toreinrichtung (21, 11) zum Einbringen und/oder Ausbringen des Werkstücks (6) in die oder aus der Hauptkammer (3), wobei durch die Toreinrichtung (21, 11) eine in einer Wand zwischen der Hauptkammer (3) und der Außenseite der Hauptkammer (3) vorgesehene Öffnung vakuumdicht geschlossen und/oder geöffnet werden kann,
eine in der Hauptkammer (3) vorgesehene Auflage (56), auf welcher das Werkstück (6) plaziert ist, und
einer in der Hauptkammer (3) vorgesehenen zweiten Kammer (5) zum Anordnen des Werkstücks (6) in dieser zweiten Kammer (5) und Isolierthalten des Werkstucks (6) von der Hauptkammer (3) während die Hauptkammer (3) evakuiert ist oder sich in einem Gaseinbringprozeß befindet.

12. Vakuumbehandlungskammer nach Anspruch 11, mit einer Drucksteuereinrichtung zum Halten eines Gasdrucks in der zweiten Kammer (5), der höher oder wenigstens gleich dem Druck in der Hauptkammer (3) ist.

13. Vakuumbehandlungskammer nach Anspruch 12, wobei die Drucksteuereinrichtung eine zweite Gaseinbringeinrichtung (51) zum Einbringen von Gas in die zweite Kammer (5) aufweist.

14. Vakuumbehandlungskammer nach Anspruch 12 oder 13, wobei die Drucksteuereinrichtung eine zweite Evakuierungseinrichtung (52) zur Evakuierung der zweiten Kammer (5) aufweist.

15. Vakuumbehandlungskammer nach einem der Ansprüche 12 bis 14, wobei die Drucksteuereinrichtung eine an einer Peripherie einer Bodenöffnung einer Vakuumglocke (5') vorgesehene Langsamleckeinrichtung aufweist.

16. Vakuumbehandlungskammer nach Anspruch 15, wobei die Langsamleckeinrichtung aus einem an der Öffnung der Vakuumglocke (5) angebrachten O-Ring (55) besteht.

17. Vakuumbehandlungskammer nach einem der Ansprüche 11 bis 16, wobei die zweite Kammer (5) eine Größe aufweist, die ausreicht, das Werkstück (6) in der zweiten Kammer (5) aufzunehmen, ansonsten aber so klein wie möglich ist.

18. Vakuumbehandlungskammer nach einem der Ansprüche 11 bis 17, wobei die zweite Kammer aus einer in der Hauptkammer (3) auf- und abwärtsbewegbaren Vakuumglocke (5') gebildet ist, wobei der Boden der Vakuumglocke (5') geöffnet ist, wenn sie angehoben ist, und unter Berührung mit der Auflage (56) geschlossen ist, wenn die Vakuumglocke (5') abgesenkt ist, um auf der Auflage (56) zu sitzen.

19. Vakuumbehandlungskammer nach einem der Ansprüche 11 bis 18, mit einer Betätigungseinrichtung (53) zum Anheben oder/oder Absenken der Vakuumglocke (5').

20. Vakuumbehandlungskammer nach einem der Ansprüche 11 bis 19, mit einer auf der Außenseite der zweiten Kammer (5) angeordneten Überführungseinrichtung (54) zum Überführen des Werkstücks (6) und Positionieren des Werkstücks (6) auf der Auflagefläche (56) und/oder Aufnehmen des Werkstücks (6) von der Auflagefläche (56).

## Revendications

1. Moyen pour charger ou décharger une pièce à traiter (6) dans ou depuis une chambre sous vide pour traiter la pièce à traiter (6) dans ladite chambre sous vide (1), comprenant :
une chambre principale (3) coupée à ladite chambre sous vide (1) et au travers de ladite chambre principale (3), la pièce à traiter (6) est chargée ou déchargée dans ou depuis ladite chambre sous vide (1) ;
un moyen d'évacuation (23) pour faire le vide dans ladite chambre principale (3) ;
un moyen d'introduction de gaz (51) pour introduire du gaz à l'intérieur de ladite chambre principale (3) ;
un premier moyen de porte (21) pour charger ou décharger ladite pièce à traiter (6) dans ou depuis ladite chambre principale (5), ledit premier moyen de porte (21) étant susceptible d'ouvrir ou de rendre étanche au vide de façon efficace une ouverture ménagée sur une paroi séparant ladite chambre principale (3) et l'extérieur de ladite chambre principale (3) ;
un second moyen de porte (11) prévu entre ladite chambre sous vide (1) et ladite chambre principale (3) pour transférer ladite pièce à traiter (6) depuis ladite chambre principale (3) dans ladite chambre sous vide (1) ou vice versa, ledit second moyen de porte (11) étant susceptible d'ouvrir ou de rendre étanche au vide de façon efficace une ouverture ménagée sur une paroi séparant ladite chambre sous vide (1) et ladite chambre principale (3) ;
une table (56) prévue dans ladite chambre principale (3) sur laquelle ladite pièce à traiter (6) est placée ; et
une seconde chambre (5) prévue dans ladite chambre principale (3) pour renfermer en son sein ladite pièce à traiter (6) et pour maintenir ladite pièce à traiter (6) isolée de ladite chambre principale (3) tandis que ladite chambre principale (3) est en cours de processus de mise sous vide ou d'introduction de gaz.

2. Moyen selon la revendication 1, comprenant en outre un moyen de commande de pression pour maintenir la pression du gaz dans ladite seconde chambre (5) supérieure ou au moins égale à celle qui règne dans la chambre principale (3).

3. Moyen selon la revendication 2, dans lequel ledit moyen de commande de pression comprend un second moyen d'introduction de gaz (51) pour introduire du gaz à l'intérieur de ladite seconde chambre (5).

4. Moyen selon la revendication 2, dans lequel ledit moyen de commande de pression comprend un second moyen d'évacuation (52) pour faire le vide dans ladite seconde chambre (5).

5. Moyen selon la revendication 2, dans lequel ledit moyen de commande de pression comprend un moyen de fuite lente prévu sur une périphérie d'une ouverture de fond dudit récipient en cloche (5').

6. Moyen selon la revendication 5, dans lequel ledit moyen de fuite lente est un joint torique d'étanchéité (55) qui est fixé à une ouverture dudit récipient en cloche (5').

7. Moyen selon la revendication 1, dans lequel ladite seconde chambre (5) présente des dimensions suffisamment importantes pour renfermer en son sein ladite pièce à traiter (6) tout en présentant des dimensions aussi petites que possible.

8. Moyen selon la revendication 1, dans lequel ladite seconde chambre est constituée par un récipient en cloche (5') susceptible d'être déplacé vers le haut et vers le bas dans ladite chambre principale (3), un fond dudit récipient en cloche (5') est ouvert lorsque celui-ci est levé et est fermé de manière à entrer en contact avec ladite table (56) lorsque ledit récipient en cloche (5') est abaissé pour reposer sur ladite table (56).

9. Moyen selon la revendication 8, comprenant en outre un moyen de déplacement (53) pour lever ou abaisser ledit récipient en cloche (5').

10. Moyen selon la revendication 1, comprenant en outre un moyen de transfert (54) positionné à l'extérieur de ladite seconde chambre (5) pour transférer ladite pièce à traiter (6), pour positionner ladite pièce à traiter (6) sur ladite table (56) ou pour saisir ladite pièce à traiter (6) pour l'amener sur ladite table (56) ou pour l'en enlever.

11. Chambre de traitement sous vide pour traiter une pièce à traiter (6) en son sein, comprenant :
une chambre principale (3) pour traiter ladite pièce à traiter (6) en son sein ;
un moyen d'évacuation (23) pour faire le vide dans ladite chambre principale (3) ;
un moyen d'introduction de gaz (22) pour introduire du gaz à l'intérieur de ladite chambre principale (3) ;
un moyen de porte (21, 11) pour charger ou décharger ladite pièce à traiter (6) à l'intérieur de ladite chambre principale (3), ledit moyen de porte (21, 11) étant susceptible d'ouvrir ou de rendre étanche au vide de façon efficace une ouverture ménagée sur une paroi séparant ladite chambre principale (3) et l'extérieur de ladite chambre principale (3) ;
une table (56) prévue dans ladite chambre principale (3) sur laquelle ladite pièce à traiter (6) est-placée ; et
une seconde chambre (5) prévue dans ladite chambre principale (3) pour renfermer en son sein ladite pièce à traiter (6) et pour maintenir ladite pièce à traiter (6) isolée par rapport à ladite chambre principale (3) tandis que ladite chambre principale (3) est en cours de processus de réalisation de vide ou d'introduction de gaz.

12. Chambre de traitement sous vide selon la revendication 11, comprenant en outre un moyen de commande de pression pour maintenir une pression de gaz dans ladite seconde chambre (5) supérieure ou au moins égale à celle qui règne dans la chambre principale (3).

13. Chambre de traitement sous vide selon la revendication 12, dans laquelle ledit moyen de commande de pression comprend un second moyen d'introduction de gaz (51) pour introduire du gaz dans ladite seconde chambre (5).

14. Chambre de traitement sous vide selon la revendication 12, dans laquelle ledit moyen de commande de pression comprend un second moyen d'évacuation (52) pour faire le vide dans ladite seconde chambre (5).

15. Chambre de traitement sous vide selon la revendication 12, dans laquelle ledit moyen de commande de pression comprend un moyen de fuite lente prévu sur la périphérie d'une ouverture de fond dudit récipient en cloche (5').

16. Chambre de traitement sous vide selon la revendication 15, dans laquelle ledit moyen de fuite lent est un joint torique d'étanchéité (55) qui est fixé à une ouverture dudit récipient en cloche (5').

17. Chambre de traitement sous vide selon la revendication 11, dans laquelle ladite seconde chambre (5) présente des dimensions suffisamment importantes pour renfermer en son sein ladite pièce à traiter (6) tout en présentant des dimensions aussi faibles que possible.

18. Chambre de traitement sous vide selon la revendication 11, dans laquelle ladite seconde chambre est constituée par un récipient en cloche (5') susceptible d'être déplacé vers le haut et vers le bas dans ladite chambre principale (3), un fond dudit récipient en cloche (5') est ouvert lorsqu'il est levé et est fermé de manière à entrer en contact avec ladite table (56) lorsque ledit récipient en cloche (5') est abaissé pour reposer sur ladite table (56).

19. Chambre de traitement sous vide selon la revendication 11, comprenant en outre un moyen de déplacement (53) pour lever ou abaisser ledit récipient en cloche (5').

20. Moyen selon la revendication 11, comprenant en outre un moyen de transfert (54) positionné à l'extérieur de ladite seconde chambre (5) pour transférer ladite pièce à traiter (6) et pour positionner ladite pièce à traiter (6) sur ladite table (56) ou pour saisir ladite pièce à traiter (6) sur ladite table (56).
